# EUROPEAN PATENT APPLICATION

(11) **EP 3 907 756 A1**
(43) Date of publication of application: **10.11.2021**
(21) Application number: 20217543.6
(22) Date of filing: 29.12.2020
(51) Int. Cl.: H01L 23/373, H01L 25/07, H01L 23/433, H01L 21/98

(54) **POWER MODULE OF DOUBLE-FACED COOLING AND MANUFACTURING METHOD THEREOF**

(30) Priority: 06.05.2020 KR 20200053998
(71) Applicant: LG Electronics, Inc., Yeongdeungpo-gu Seoul 07336 (KR)
(72) Inventor: LEE, Gun, 08592 Seoul (KR); CHO, Seongmoo, 08592 Seoul (KR); KIM, Kwangsoo, 08592 Seoul (KR); CHOI, Siho, 08592 Seoul (KR)
(74) Representative: Vossius & Partner Patentanwälte Rechtsanwälte mbB

(57) **Abstract**

An implementation of the present disclosure discloses a power module of double-sided cooling. The power module includes a pair of substrates spaced apart from each other and a plurality of power elements disposed between the pair of substrates. The plurality of power elements is bonded to the pair of substrates in a dividing manner, so that heat generated from the power elements can be uniformly dissipated to the pair of substrates.

## Description

### BACKGROUND

### 1. Technical Field

The present disclosure relates to a power module and a method for manufacturing the same, and more particularly, to a power module of double-sided cooling having uniform heat dissipation performance, and a method for manufacturing the same.

### 2. Description of the Related Art

Home appliances such as compressors and air conditioners are provided with motors that convert electrical energy into driving energy. A motor may be driven by receiving power from an external power source of direct-current (DC) voltage.

In this case, the motor may be provided with an inverter that converts the DC voltage into a three-phase voltage. The inverter may include a power element that performs a switching operation, which is an operation of supplying power for driving the motor using supplied power.

A semiconductor device such as a gate turn-off thyristor (GTO) or an insulated gate bipolar transistor (IGBT) may be used as the power element.

When the power element performs a switching operation, thermal energy is generated in the power element, and accordingly, temperatures of the power element and a power module are increased. If the internal temperature of the power module is excessively increased, damage to the power element may occur. The damage to the power element may cause a decrease in the output of the motor, and furthermore, the operation of the motor may be stopped.

To prevent these problems, the power module is provided with a heat sink that is in contact with the power element to dissipate heat from the power element. The power module may have the heat sink on one surface or each of both surfaces.

The heat sinks are coupled in contact with two substrates between which the power element is interposed.

Heat generated from the power element may be transferred to the two substrates and efficiently dissipated through the heat sinks in contact with the respective substrates.

However, there may be a problem in that heat generated in the power element is biased to any one substrate without being uniformly transferred to the both substrates.

In this case, thermal stress, which is a stress caused by thermal expansion, may be excessively generated on any one substrate, or distortion may occur due to non-uniform generation of the stress.

If excessive thermal stress is generated on any one of the substrates, damage such as cracks may occur on the substrate, and if distortion occurs in the power module, damage to bonding between components or parts may occur or damage to each component itself may occur.

Further, the power element and a thermal-conductive member may be bonded by a bonding layer interposed therebetween. The bonding layer may be formed by soldering or sintering a bonding material having thermal conductivity and electrical conductivity.

The power element and the thermal-conductive member are bonded to each other by melting the bonding material, and then coupled to each other during the process of solidifying the bonding material again.

However, since a difference in speed at which each portion of the bonding material is solidified may be caused, the bonding layer may be tilted when the power element and the thermal-conductive member are coupled to each other.

In addition, due to the tilting of the bonding layer, an assembly error of the power module may be caused.

Since the power module is a device that requires precise assembly, even a minute assembly error may lead to defects in the device.

For example, when the internal temperature of the power module is excessively increased, a problem that stress is intensively applied to a specific portion may occur. When the stress applied to the power element is excessively increased, the performance of the power element performing the switching operation may be deteriorated, and thereby the power element may be damaged.

In addition, due to the tilting, a separation may occur between the heat sink and the thermal-conductive member. This may cause deterioration of heat dissipation performance of the power module.

The prior art document (Korean Registration Patent Publication No. 10-1786343) discloses a power module in which heat generated from a power element is dissipated to both surfaces of a power element.

However, since the power element of the power module is concentrated on one substrate, there may be a problem in that heat generated from the power element is excessively biased to the one substrate.

In addition, the tilting may occur in the power module when the power element and the thermal-conductive member are bonded to each other, which may cause an excessive increase in stress in the power module and deterioration of heat dissipation performance, resulting in an excessive temperature rise.

That is, the prior art literature has a limitation in that there is no consideration for solving the problem that an amount of heat dissipated is not uniform and the problem that the tilting occurs upon coupling the power module.

### [Prior Art Literature]

### [Patent Literature]

Korean Registration Patent Publication No. 10-1786343 (October 18, 2017)

### SUMMARY

The present disclosure is directed to providing a double-faced cooling type power module having a structure capable of solving the above-described problems and a method for manufacturing the same.

First, one aspect of the present disclosure is to provide a double-faced cooling type power module having a structure capable of uniformly dissipating heat generated from a power element to both surfaces of the power element, and a method for manufacturing the same.

Another aspect of the present disclosure is to provide a double-faced cooling type power module having a structure capable of suppressing excessive thermal stress from being generated on any one of substrates provided on both surfaces of a power element, and a method for manufacturing the same.

Still another aspect of the present disclosure is to provide a double-faced cooling type power module having a structure capable of suppressing occurrence of warpage or distortion caused by a non-uniform stress, and a method for manufacturing the same.

Still another aspect of the present disclosure is to provide a double-faced cooling type power module having a structure capable of suppressing tilting caused when a power element and a thermal-conductive member are coupled to each other, and a method for manufacturing the same.

In order to achieve these and other advantages and in accordance with the purpose of this specification, as embodied and broadly described herein, there is provided a power module of double-sided cooling according to an implementation of the present disclosure which may include a power element that performs a switching operation.

In addition, a pair of substrates may be disposed at both sides of the power element. The power element may be electrically connected to the pair of substrates with being interposed between the pair of substrates.

In addition, the power element may be provided in plurality. Some of the plurality of power elements may be bonded to any one of the pair of substrates, and the rest of the plurality of power elements may be bonded to the other of the pair of substrates.

The number of power elements coupled to the one of the pair of substrates and the number of power elements coupled to the other of the pair of substrates may be the same.

A power module according to an implementation of the present disclosure may include a first substrate and a second substrate disposed to be spaced apart from each other by a predetermined distance, and a power element and a spacer disposed between the first substrate and the second substrate.

The spacer may include a first spacer electrically coupled to one surface of the second substrate facing the first substrate, and a second spacer electrically coupled to one surface of the first substrate facing the second substrate.

The power element may include a first power element disposed between the first spacer and the first substrate, and having both surfaces thereof electrically coupled to the first spacer and the first substrate, respectively, and a second power element disposed between the second spacer and the second substrate, and having both surfaces thereof electrically coupled to the second spacer and the second substrate, respectively.

Each of the first and second substrates may include an insulating plate, and metal plates disposed on both surfaces of the insulating plate.

The first substrate and the second spacer may be coupled to a metal plate disposed on one surface of the first substrate facing the second substrate, and the second substrate and the first spacer may be coupled to a metal plate disposed on one surface of the second substrate facing the first substrate.

The first and second power elements may be configured as insulated gate bipolar transistor (IGBT) semiconductor devices.

The first and second power elements may be provided in plurality, respectively. The first power elements and the second power elements may be provided in the same number.

The first and second power elements may be provided in plurality. The plurality of first power elements may be disposed to be spaced apart from each other by a predetermined distance along a first row, and the plurality of second power elements may be disposed to be spaced apart from each other by a predetermined distance along a second row spaced apart from the first row.

The first and second power elements may be provided in plurality. At least one of the plurality of second power elements may be disposed between the plurality of first power elements, and at least one of the plurality of first power elements may be disposed between the plurality of second power elements.

The first and second power elements may be provided in plurality. The plurality of first and second power elements may be disposed to be spaced apart from each other by a predetermined distance along the first row and the second row spaced apart from the first row. At least one of the plurality of second power elements may be disposed between the plurality of first power elements disposed in the first row, and at least one of the plurality of first power elements may be disposed between the plurality of second power elements disposed in the second row.

The power module may further include a plurality of bonding layers formed between the power element and the spacer, between the power element and the first substrate, and between the spacer and the second substrate, respectively. At least one of the plurality of bonding layers may include a plurality of anti-tilting members.

The plurality of anti-tilting members each may have a predetermined height in a direction that the first and second substrates face each other. The anti-tilting members may be melted at a higher temperature than the plurality of bonding layers.

The bonding layers each may have a predetermined thickness in the direction that the first substrate and the second substrate face each other, and the predetermined height of the anti-tilting member and the predetermined thickness of the bonding layer may be equal to each other.

A difference between a shortest distance between the first substrate and the second substrate at one end of the first substrate and a shortest distance between the first substrate and the second substrate at another end of the first substrate opposite to the one end may be 200 um or less.

A method for manufacturing a power module according to an implementation of the present disclosure may include (a) forming bonding layers respectively on one surface of a first substrate and one surface of a second substrate facing each other, (b) bonding a first power element and a second spacer to the bonding layer of the first substrate, (c) bonding a second power element and a first spacer to the bonding layer of the second substrate, (d) forming bonding layers respectively on one surface of the first power element and one surface of the second spacer facing the second substrate, (e) bonding the first spacer to the bonding layer formed on the first power element and the second power element to the bonding layer formed on the second spacer, and (f) coupling the first substrate and the second substrate to each other.

The bonding layers each may include a plurality of anti-tilting members. The plurality of anti-tilting members each may have a predetermined height in a direction that the first and second substrates face each other. The anti-tilting members may be melted at a higher temperature than the plurality of bonding layers.

The first and second power elements may be provided in plurality. The first power elements and the second power elements may be provided in the same number.

The first and second power elements may be provided in plurality. The plurality of first and second power elements may be disposed to be spaced apart from each other by a predetermined distance along a first row and a second row spaced apart from the first row. At least one of the plurality of second power elements may be disposed between the plurality of first power elements disposed in the first row, and at least one of the plurality of first power elements may be disposed between the plurality of second power elements disposed in the second row.

According to implementations of the present disclosure, the following effects can be obtained.

First, a power module according to an implementation of the present disclosure may include a power element disposed between a pair of substrates.

In addition, the power element may be provided in plurality. Some of the plurality of power elements may be bonded to any one of the pair of substrates, and the rest of the plurality of power elements may be bonded to the other of the pair of substrates.

By virtue of the bonding structure, heat generated from the plurality of power elements can be uniformly dissipated to the pair of substrates without being biased to any one of the substrates.

Accordingly, excessive thermal stress can be suppressed from being produced in any one of the substrates located on both sides of the power element, thereby suppressing damage to the substrates due to the excessive thermal stress.

Furthermore, warpage or distortion of the power module which may be caused due to the generation of excessive thermal stress on one of the substrates can be suppressed. This may result in preventing an occurrence of damage to the coupling or bonding among those components of the power module or damage to the components of the power module.

In addition, members for preventing an occurrence of tilting may be included in bonding layers connecting those components, thereby suppressing an occurrence of tilting in the power module when assembling the power module.

### BRIEF DESCRIPTION OF THE DRAWINGS

FIG. 1 is an exploded perspective view of a power module in accordance with an implementation of the present disclosure.
FIG. 2 is a cross-sectional view illustrating a substrate according to FIG. 1.
FIG. 3 is a cross-sectional view illustrating the power module according to FIG. 1, taken along the line III - III.
FIG. 4 is a cross-sectional view illustrating the power module according to FIG. 1, taken along line IV - IV.
FIG. 5 is a cross-sectional view illustrating the power module according to FIG. 1, taken along the line V - V.
FIG. 6 is a cross-sectional view illustrating another implementation of the power module according to FIG. 5.
FIG. 7 is a planar view illustrating the power module according to FIG. 1.
FIG. 8 is an enlarged partial cross-sectional view illustrating an area A of FIG. 3.
FIG. 9 is a perspective view illustrating a bonding layer according to FIG. 1.
FIG. 10 is a perspective view illustrating another implementation of the bonding layer according to FIG. 9.
FIG. 11 is a cross-sectional view illustrating the bonding layer according to FIG. 9, taken along the line X - X.
FIG. 12 is a flowchart illustrating a process of manufacturing a power module in accordance with one implementation of the present disclosure.

### DETAILED DESCRIPTION OF THE IMPLEMENTATIONS

Hereinafter, a power module for double-faced cooling according to implementations of the present disclosure will be described in detail with reference to the accompanying drawings.

In the following description, descriptions of some components will be omitted in order to clarify the features of the present disclosure.

### 1. Definition of Terms

The term "electrical connection" used in the following description means that one component is electrically connected to another component or is connected to enable information communication with another component. The electrical connection may be enabled by conductive wires, communication cables, or the like.

The term "thermal conduction efficiency" used in the following description is an index indicating an amount of heat transferred per unit time and is affected by distance. Thermal conduction is lowered as a distance between two objects connected by a thermal conductor increases, and is improved as the distance between the two objects connected by the thermal conductor decreases.

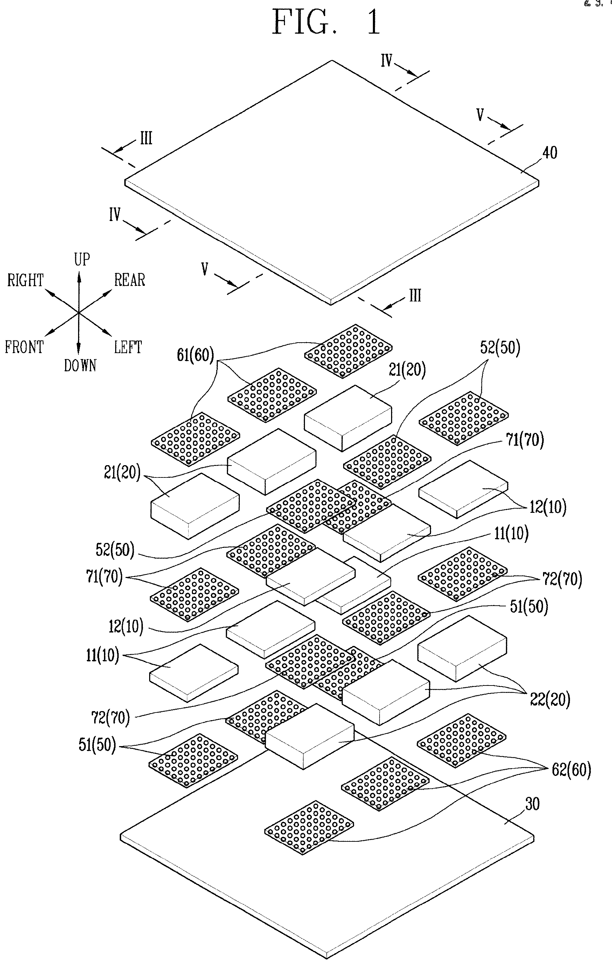

The terms "left", "right", "front", "rear", "upper" and "lower" used in the following description will be understood with reference to a coordinate system shown in FIG. 1.

### 2. Description of Configuration of Power module 1 according to One Implementation

Referring to FIGS. 1 to 3, a power module 1 for converting power supplied from an external power source (not illustrated) into a three-phase voltage is illustrated.

A power module 1 according to one implementation of the present disclosure may include a power element 10, a spacer 20, substrates 30 and 40, bonding layers 50, 60, and 70, an insulation part 80, and anti-tilting members 100.

Although not illustrated, the power module 1 according to the one implementation of the present disclosure may include a semiconductor component such as a diode (not illustrated) in addition to the power element 10.

Hereinafter, each configuration of the power module 1 will be described in detail.

### (1) Description of Power element 10

The power element 10 may perform a switching operation, which is an operation of converting power supplied from an external power source into power for driving a motor and supplying the converted power.

A semiconductor device such as an insulated gate bipolar transistor (IGBT) may be used as the power element 10. However, the present disclosure is not limited thereto, and other known semiconductor devices may be used. For example, a gate turn-off thyristor (GTO) may be used as the power element 10.

In one implementation, the power element 10 may include electrodes formed on both surfaces thereof. For example, a gate electrode and an emitter electrode may be provided on an upper surface of the power element 10, and a collector electrode may be provided on a lower surface of the power element 10. Each electrode that may be provided on the power element 10 is a well-known technology, and thus a detailed description thereof will be omitted.

Since high power is required for the switching operation performed by the power element 10, high heat may be generated, compared to other general chips.

When heat is excessively generated, damage to the power module 1 may occur. Thus, a heat sink for dissipating heat generated from the power element 10 may be provided in the power module 1.

In one implementation, the heat sink may be implemented as a heat dissipation plate (not illustrated).

In order to dissipate heat from the power element 10 more efficiently, the power module 1 may have a double-faced (double-sided) cooling structure that dissipates heat to both sides of the power element 10.

In the double-faced cooling structure, the substrates 30 and 40 may be provided on upper and lower sides of the power element 10, and each of the substrates 30 and 40 may be coupled to a heat sink (not illustrated) for dissipating heat transferred from the power element 10 in a contact manner.

The power element 10 may include a first power element 11 coupled to the first substrate 30 disposed on the lower side and a second power element 12 coupled to the second substrate 40 disposed on the upper side. The arrangement of the first power element 11 and the second power element 12 will be described in detail later as a separate content.

In addition, a spacer for securing an insulation distance between the substrates 30 and 40 may be provided.

### (2) Description of Spacer 20

The spacer 20 may be connected to the power element 10 in a manner of facing one surface of the power element 10, and disposed such that the substrates 30 and 40 located on the upper and lower sides of the power element are spaced apart from each other.

Accordingly, an insulation distance between the substrates 30 and 40 may be secured.

The spacer 20 may have a predetermined height to secure the insulation distance between the substrates 30 and 40, and may be disposed between the power element 10 and the substrate 30, 40.

Specifically, both surfaces of the spacer 20 may be coupled to the power element 10 and the substrate 30, 40.

In the illustrated implementation, the spacer 20 may include a first spacer 21 having a lower surface coupled to the first power element 11 and an upper surface coupled to the second substrate 40, and a second spacer 22 having an upper surface coupled to the second power element 12 and a lower surface coupled to the first substrate 30.

The first spacer 21 may allow the first power element 11 and the second substrate 40 to be electrically connected to each other and simultaneously secure an insulation distance between the first and second substrates 30 and 40.

In addition, the second spacer 22 may allow the second power element 12 and the first substrate 30 to be electrically connected to each other and simultaneously secure an insulation distance between the first and second substrates 30 and 40.

The spacer 20 may be formed of a material having excellent thermal conductivity and electrical conductivity. For example, the spacer 20 may be formed of a material such as Al-Si-C or Cu.

Accordingly, an electrode formed on the power element 10 and a metal portion of the substrate 30, 40 may be electrically connected to each other through the spacer 20.

Furthermore, heat generated from the power element 10 may be transferred to the first and second substrates 30 and 40 located at the upper and lower sides of the power element 10 through the spacer 20.

Heat sinks (not illustrated) may be coupled to the lower surface of the first substrate 30 and the upper surface of the second substrate 40 in a contact manner, respectively, so that heat transferred to the first and second substrates 30 and 40 can be dissipated through the heat sinks (not illustrated).

### (3) Description of Substrates 30 and 40

The first and second substrates 30 and 40 may be provided at the upper and lower sides of the power element 10, respectively. The first substrate 30 may be disposed at the lower side of the power element 10, and the second substrate 40 may be disposed at the upper side of the power element 10.

That is, the first substrate 30 and the second substrate 40 may be spaced apart from each other by a predetermined distance with the power element 10 interposed therebetween.

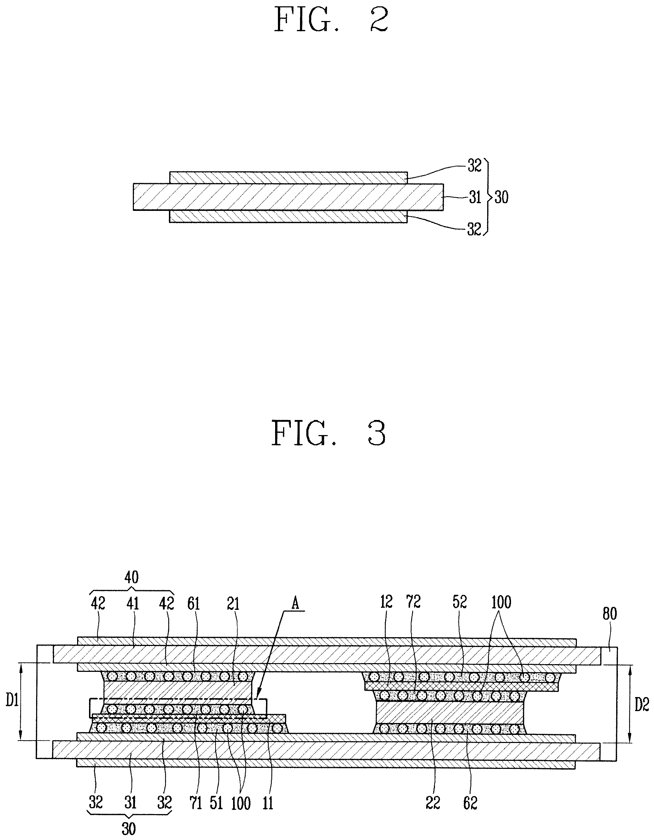

Referring to FIG. 2, the first substrate 30 and the second substrate 40 may be implemented as insulating plates 31 and 41 each having metal plates 32 and 42 on both upper and lower surfaces thereof.

That is, the first substrate 30 may include a first insulating plate 31 and first metal plates 32 disposed on both upper and lower surfaces of the first insulating plate 31, and the second substrate 40 may include a second insulating plate 41 (see FIG. 3) and second metal plates 42 (see FIG. 3) disposed on both upper and lower surfaces of the second insulating plate 41.

The first insulating plate 31 and the second insulating plate 41 may be formed of a material having high thermal conductivity and insulating properties. Accordingly, it may be possible to insulate between the first metal plates 32 and between the second metal plates 42 and simultaneously to smoothly transfer heat generated from the power element 10.

The first metal plates 32 and the second metal plates 42 may be electrically connected to the power element 10 and the spacer 20 so as to transmit electrical signals generated from the power element 10.

The first metal plate 32 disposed on the upper surface of the first substrate 30 may be electrically connected to an electrode disposed on the lower surface of the first power element 11. The first metal plate 32 disposed on the upper surface of the first substrate 30 may be located at a position corresponding to the electrode disposed on the lower surface of the first power element 11.

In one implementation, the first metal plate 32 disposed on the upper surface of the first substrate 30 may be formed in various shapes according to the arrangement structure of the first power element 11.

In addition, the second metal plate 42 disposed on the lower surface of the second substrate 40 may be electrically connected to an upper surface of the first spacer 21. In this case, the second metal plate 42 may be located at a position corresponding to the first spacer 21.

In one implementation, the second metal plate 42 disposed on the lower surface of the second substrate 40 may be formed in various shapes according to the arrangement structure of the first spacer 21.

That is, the second metal plate 42 disposed on the lower surface of the second substrate 40 may be electrically connected to the electrode disposed on the upper surface of the first power element 11.

The second metal plate 42 disposed on the lower surface of the second substrate 40 may be electrically connected to the electrode disposed on the upper surface of the second power element 12. The second metal plate 42 disposed on the lower surface of the second substrate 40 may be located at a position corresponding to the electrode disposed on the upper surface of the second power element 12.

In one implementation, the second metal plate 42 disposed on the lower surface of the second substrate 40 may be formed in various shapes according to the arrangement structure of the second power element 12.

In addition, the first metal plate 32 disposed on the upper surface of the first substrate 30 may be electrically connected to a lower surface of the second spacer 22. In this case, the first metal plate 32 may be located at a position corresponding to the second spacer 22.

In one implementation, the first metal plate 32 disposed on the upper surface of the first substrate 30 may be formed in various shapes according to the arrangement structure of the second spacer 22.

That is, the first metal plate 32 disposed on the upper surface of the first substrate 30 may be electrically connected to the electrode disposed on the lower surface of the second power element 12.

The first substrate 30 and the second substrate 40 may be implemented as direct bonded copper (BDC) substrates. However, the present disclosure is not limited thereto, and may be implemented as various known substrates that can be used in the power module 1.

Heat sinks (or heat dissipation plates) (not illustrated) may be coupled to the lower surface of the first substrate 30 and the upper surface of the second substrate 40, respectively, in the contact manner.

Heat generated from the first power element 11 may be dissipated to the heat sink through the first substrate 30. In addition, heat generated from the first power element 11 may be dissipated to the heat sink through the first spacer 21 and the second substrate 40.

Heat generated from the second power element 12 may be dissipated to the heat sink through the second substrate 40. In addition, heat generated from the second power element 12 may be dissipated to the heat sink through the second spacer 22 and the first substrate 30.

With the configuration, heat generated from the power element 10 can be dissipated to both upper and lower surfaces of the power element 10.

Accordingly, heat dissipation performance of dissipating heat generated from the power element 10 can be improved.

This may result in suppressing an excessive increase in internal temperature of the power module 1 due to heat generation in the power element 10.

A bonding layer may be disposed between two members, facing each other, among the power element 10, the spacer 20, the first substrate 30, and the second substrate 40. The two members may be firmly coupled to each other by the bonding layer.

### (4) Description of Bonding layers 50, 60, and 70

The bonding layers 50, 60, and 70 may bond (couple) two members facing each other.

Each of the bonding layers 50, 60, and 70 may include first bonding layers 51, 61, 71 and second bonding layers 52, 62, 72.

The first bonding layer 51 may be disposed between the first substrate 30 and the first power element 11. The first substrate 30 and the first power element 11 may be electrically connected to each other by the first bonding layer 51.

The first bonding layer 71 may be disposed between the first power element 11 and the first spacer 21. The first power element 11 and the first spacer 21 may be electrically connected to each other by the first bonding layer 51.

The first bonding layer 61 may be disposed between the first spacer 21 and the second substrate 40. The first spacer 21 and the second substrate 40 may be electrically connected to each other by the first bonding layer 61.

The second bonding layer 52 may be disposed between the second substrate 40 and the second power element 12. The second substrate 40 and the second power element 12 may be electrically connected to each other by the second bonding layer 52.

The second bonding layer 72 may be disposed between the second power element 12 and the second spacer 22. The second power element 12 and the second spacer 22 may be electrically connected to each other by the second bonding layer 51.

The second bonding layer 62 may be disposed between the second spacer 22 and the first substrate 30. The second spacer 22 and the first substrate 30 may be electrically connected to each other by the second bonding layer 62.

A bonding material having excellent thermal conductivity and electrical conductivity may be used for each of the bonding layers 50, 60, and 70, and each of the bonding layers 50, 60, and 70 may be formed in a soldering or sintering manner.

Such bonding material forming the bonding layers 50, 60, and 70 may include Ag, Cu, Sn-Cu, or the like.

### (5) Description of Insulation part 80

The insulation part 80 may be disposed between the first substrate 30 and the second substrate 40. The insulation part 80 may prevent insulation breakdown from occurring between the adjacent power elements 10 or between the first and second substrates 30 and 40.

The insulation part 80 may be formed by molding an insulating material between the first substrate 30 and the second substrate 40.

Hereinafter, an arrangement structure of the power element 10 according to the implementation of the present disclosure will be described with reference to FIGS. 3 to 7.

### 3. Description of Arrangement structure of Power element 10 according to Implementation

Referring to FIG. 3, the power element 10 according the one implementation may be provided in plurality. Some of the plurality of power elements 10 may be coupled to any one of the pair of substrates 30 and 40 and the rest of the plurality of power elements 10 may be coupled to another one of the pair of substrates 30 and 40.

In the illustrated implementation, the plurality of power elements 10 may include the first power element 11 coupled to the first substrate 30 and the second power element 12 coupled to the second substrate 40.

The lower surface of the first power element 11 may be electrically coupled to the upper surface of the first substrate 30 by the first bonding layer 51. In addition, the upper surface of the first power element 11 may be electrically coupled to the lower surface of the first spacer 21 by the first bonding layer 71, and the first spacer 21 may be coupled to the second substrate 40 by the first bonding layer 61.

Since the first bonding layers 51, 61 and 71 and the first spacer 21 are formed of the material having thermal conductivity and electrical conductivity, the first power element 11 may be electrically connected to the first and second substrates 30 and 40, so that heat generated from the first power element 11 can be transferred to the first and second substrates 30 and 40.

However, there is a difference between thermal conduction efficiency that heat generated from the first power element 11 is transferred to the first substrate 30 and thermal conduction efficiency that the heat is transferred to the second substrate 40.

The thermal conduction efficiency is an index indicating an amount of heat transferred per unit time and is affected by distance. Thermal conduction is lowered as a distance between two objects increases, and is improved as the distance between the two objects decreases.

The first substrate 30 may be directly coupled to the first power element 11, while the second substrate 40 may be coupled to the first power element 11 with the first spacer 21 interposed therebetween.

Therefore, the thermal conduction efficiency between the first power element 11 and the second substrate 40 may be lower than the thermal conduction efficiency between the first substrate 30 coupled to the first power element 11 and the first power element 11.

As a result, a relatively larger amount of thermal energy may be transferred to the first substrate 30 than to the second substrate 40.

Also, the upper surface of the second power element 12 may be electrically coupled to the lower surface of the second substrate 40 by the second bonding layer 52. In addition, the lower surface of the second power element 12 may be electrically coupled to the upper surface of the second spacer 22 by the second bonding layer 72, and the second spacer 22 may be coupled to the first substrate 30 by the second bonding layer 62.

Since the second bonding layers 52, 62 and 72 and the second spacer 22 are formed of the material having thermal conductivity and electrical conductivity, the second power element 12 may be electrically connected to the first and second substrates 30 and 40, so that heat generated from the second power element 12 can be transferred to the first and second substrates 30 and 40.

However, there is a difference between thermal conduction efficiency that heat generated from the second power element 12 is transferred to the first substrate 30 and thermal conduction efficiency that the heat is transferred to the second substrate 40.

The second substrate 40 may be directly coupled to the second power element 12, while the first substrate 30 may be coupled to the second power element 12 with the second spacer 22 interposed therebetween.

Therefore, the thermal conduction efficiency between the second power element 12 and the first substrate 30 may be lower than the thermal conduction efficiency between the second substrate 40 coupled to the second power element 12 and the second power element 12.

As a result, a relatively larger amount of thermal energy may be transferred to the second substrate 40 than to the first substrate 30.

That is, as described above, the heat generated from the first power element 11 may be transferred in a relatively larger amount to the first substrate 30 than to the second substrate 40, and the heat generated from the second power element 12 may be transferred in a relatively large amount to the second substrate 40 than to the first substrate 30.

If both the first and second power elements 11 and 12 are bonded to only one of the first substrate 30 or the second substrate 40, thermal energy generated from the first and second power elements 11 and 12 may be transferred while being biased to the only one of the first substrate 30 or the second substrate 40.

If thermal energy is transferred with being excessively biased to any one of the first substrate 30 and the second substrate 40, excessive thermal stress may be caused due to thermal expansion.

Accordingly, damage such as cracks may occur on the substrate.

In addition, as magnitudes of thermal energy transferred to the first substrate 30 and the second substrate 40 vary, a thermally expanded degree of the first substrate 30 and a thermally expanded degree of the second substrate 40 may be different from each other.

Accordingly, warpage or distortion may occur in the power module 1, which may cause damage to the coupling or bonding of components of the power module 1 and thus cause damage to the components of the power module 1.

In the power module 1 according to the implementation, some of the plurality of power elements 10 may be coupled to the first substrate 30, and the rest of the plurality of power elements 10 may be coupled to the second substrate 40.

By virtue of the coupling structure, heat generated from the plurality of power elements 10 can be uniformly dissipated to the pair of substrates 30 and 40 without being biased to any one of the substrates 30 and 40.

Accordingly, excessive thermal stress can be suppressed from being generated in any one of the substrates 30 and 40 provided at both sides of the power element 10, thereby suppressing damage to the substrates 30 and 40 due to the excessive thermal stress.

Furthermore, the warpage or distortion of the power module 1 which may be caused due to the generation of the excessive thermal stress on one of the substrates 30 and 40 can be suppressed.

This may result in preventing an occurrence of damage to the coupling or bonding among those components of the power module 1 or damage to the components of the power module 1.

As a result, reliability against heat generated from the power element 10 can be improved.

In the illustrated implementation, a total of six power elements 10 may be provided. However, the present disclosure is not limited thereto. In an implementation not illustrated, the number of power elements 10 may vary depending on a circuit design of the power module 1.

For uniform heat dissipation performance of the power module 1, the first power element 11 and the second power element 12 may be provided in the same number.

In the illustrated implementation, the first and second power elements 11 and 12 may be provided by three in number, respectively.

In addition, the first power elements 11 may be arranged along a first row in a spacing manner by a predetermined distance, and the second power elements 12 may be arranged along a second row, which is spaced apart from the first row, in a spacing manner by a predetermined distance. Referring to FIG. 1, the first row and the second row may be defined in a front and rear direction.

In the illustrated implementation, the second row may be spaced a predetermined distance from the first row in a left direction.

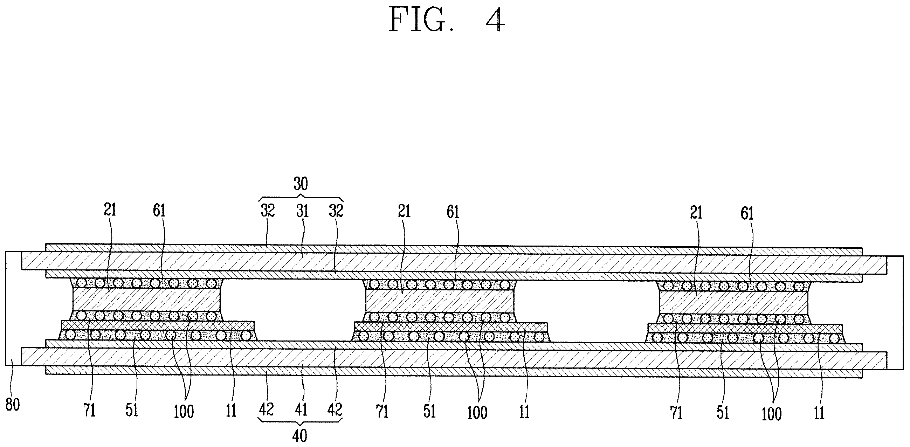

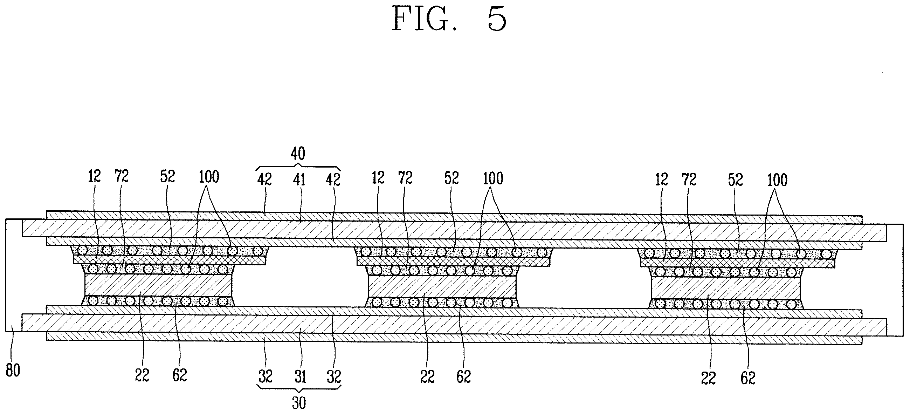

Referring to FIG. 4, a cross section including the first power elements 11 arranged along the first row is shown. In addition, referring to FIG. 5, a cross section including the second power elements 11 arranged along the second row is shown.

A ratio of thermal conduction efficiency between the first power elements 11 disposed in the first row and the first substrate 30 and thermal conduction efficiency between the first power elements 11 and the second substrate 40 may be represented as A: B. The number A may be greater than the number B.

A ratio of thermal conduction efficiency between the second power elements 12 disposed in the second row and the second substrate 40 and thermal conduction efficiency between the second power elements 12 and the first substrate 30 may be represented as A: B. The number A may be greater than the number B.

In one implementation, the thermal conduction efficiency between the first power elements 11 disposed in the first row and the first substrate 30 and the thermal conduction efficiency formed between the second power elements 12 disposed in the second row and the second substrate 40 may be substantially the same.

In order to obtain uniform heat dissipation performance, the shortest distance between the first power elements 11 disposed in the first row and the second substrate 40 may be substantially the same as the shortest distance between the second power elements 12 disposed in the second row and the first substrate 30.

In order to obtain the uniform heat dissipation performance, a spacing between the adjacent first power elements of the plurality of first power elements 11 in the first row may also be substantially the same as a spacing between the adjacent second power elements of the plurality of second power elements 12 in the second row.

In addition, in order to obtain the uniform heat dissipation performance, a distance by which the first row is spaced to the left apart from a right edge of the first substrate 30 may be substantially the same as a distance by which the second row is spaced to the right apart from a left edge of the second substrate 40.

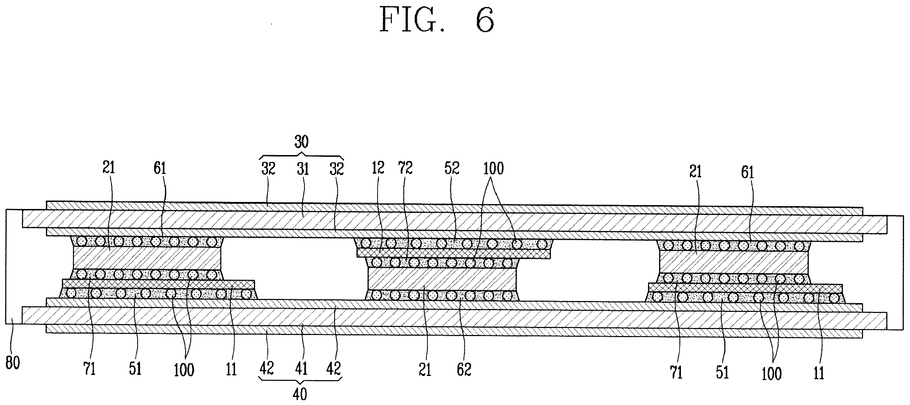

Referring to FIG. 6, a cross section of the power module 1 according to another implementation of the present disclosure is shown.

In the power module 1 according to this implementation, the order in which the first power element 11 and the second power element 12 are arranged is changed.

In the illustrated implementation, the first power element 11 and the second power element 12 are disposed to be spaced apart from each other by a predetermined distance along the first row.

At least one of the second power elements 12 may be disposed between the adjacent first power elements 11 of the plurality of first power elements 11 arranged in the first row. In the illustrated implementation, the second power element 12 may be disposed between the first power elements 11 adjacent to each other.

Although not illustrated, the first power elements 11 and the second power elements 12 may be disposed to be spaced apart from each other by a predetermined distance along the second row.

In this case, at least one of the first power elements 11 may be disposed between the adjacent second power elements 12 of the plurality of second power elements 12 arranged in the second row. In one implementation, the first power element 11 may be disposed between the second power elements 12 adjacent to each other.

In other words, the plurality of first and second power elements 11 and 12 may be disposed along the first row and the second row spaced apart from the first row to be spaced apart from each other by a predetermined distance. At least one second power element 12 may be disposed between the plurality of first power elements 11 arranged in the first row, and at least one first power element 11 may be disposed between the plurality of second power elements 12 arranged in the second row.

In one implementation, the thermal conduction efficiency between the first power elements 11 and the first substrate 30 and the thermal conduction efficiency between the second power elements 12 and the second substrate 40 may be substantially the same.

In order to obtain uniform heat dissipation performance, the shortest distance between the first power elements 11 and the second substrate 40 may be substantially the same as the shortest distance between the second power elements 12 and the first substrate 30.

In order to obtain the uniform heat dissipation performance, a spacing between the adjacent power elements 11, 12 of the plurality of power elements 11, 12 in the first row may also be substantially the same as a spacing between the adjacent power elements 11, 12 of the plurality of power elements 11, 12 in the second row.

In addition, in order to obtain the uniform heat dissipation performance, a distance by which the first row is spaced to the left apart from a right edge of the first substrate 30 may be substantially the same as a distance by which the second row is spaced to the right apart from a left edge of the second substrate 40.

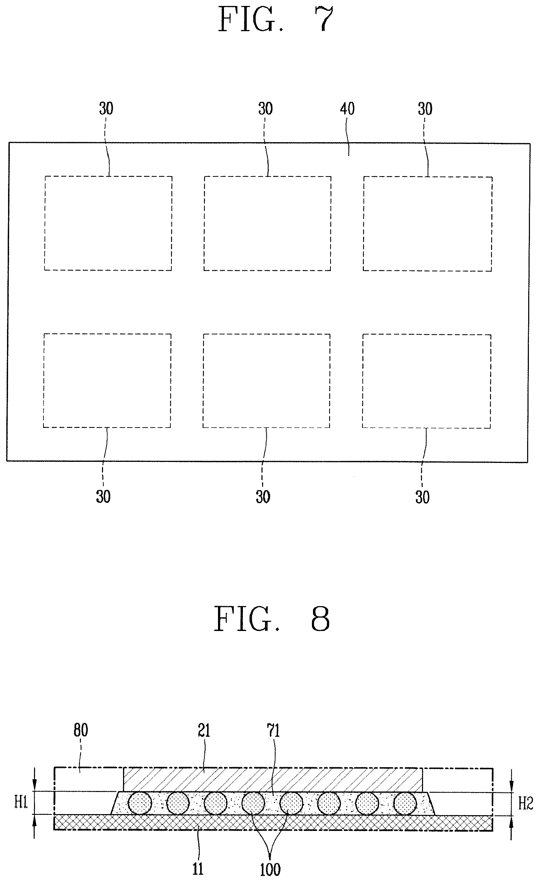

Referring to FIG. 7, a planar view of the second substrate 40 viewed from top is shown.

In order to obtain the uniform heat dissipation performance, the plurality of power elements 10 may be arranged symmetrically with respect to an imaginary line extending in a vertical direction through centers of the first and second substrates 30 and 40.

In order to obtain the uniform heat dissipation performance, the plurality of power elements 10 may also be arranged symmetrically with respect to an imaginary line extending in a horizontal direction through the centers of the first and second substrates 30 and 40.

In addition, in order to obtain the uniform heat dissipation performance, half of the plurality of power elements 10 may be coupled to the first substrate 30 and the other half may be coupled to the second substrate 40.

Hereinafter, with reference to FIGS. 8 to 11, a description will be given of the anti-tilting member 100 for suppressing the occurrence of tilting when assembling the power module 1 according to the present disclosure.

### 4. Description of Anti-tilting member 100

The power module 1 according to the implementation may include the anti-tilting member 100 in at least one of the bonding layers 50, 60, and 70.

The bonding layers 50, 60, and 70 may be formed through a process of melting a bonding material between two members to be bonded, and solidifying the melted bonding material. As the melted bonding material is solidified, the two members may be bonded to each other.

However, during the process of solidifying the melted bonding material, a difference may occur between a speed at which a portion of the melted bonding material is solidified and a speed at which another portion is solidified.

Accordingly, a difference in thickness between arbitrary two portions of the bonding layer may be increased.

As a result, two members that are bonded to each other by the bonding layer may be bonded at a predetermined angle. That is, one of the two members bonded to each other may be inclined with respect to the other member.

### (1) Description of Anti-tilting structure according to Implementation

Referring to FIG. 8, in consideration of the fact that tilting may occur when assembling the power module 1, the power module 1 according to the implementation may include an anti-tilting member 100 in at least one of the bonding layers 50, 60, and 70.

The anti-tilting member 100 may be provided in plural each having a predetermined height in an up and down direction. The predetermined height may be designed in consideration of a thickness of each of the bonding layers 50, 60, and 70 in the up and down direction. That is, the anti-tilting member 100 may have a height equal to a design thickness of the bonding layers 50, 60, and 70.

The anti-tilting member 100 may be formed in a spherical shape.

The plurality of anti-tilting members 100 may be disposed between two members to be bonded in a state of being contained in a melted bonding material. When the bonding material is solidified to form the bonding layer 50, 60, 70 containing the anti-tilting members 100, the anti-tilting members 100 may support the two members together with the bonding layer 50, 60, 70.

Explaining the bonding layer 50 formed between the power element 10 and the spacer 20 as an example, the bonding layer 50 may include the plurality of anti-tilting members 100, and the anti-tilting members 100 may support the power element 10 and the spacer 20 together with the bonding layer 50 between the power element 10 and the spacer 20.

The anti-tilting member 100 may be formed of a material that does not melt at a temperature at which the bonding material forming the bonding layer 50, 60, and 70 is melted.

Accordingly, during the process of melting the bonding material, the anti-tilting members 100 may be disposed by being included in the melted bonding material without being melted.

In addition, the anti-tilting member 100 may be formed of a material that does not react with the bonding material while being included in the melted bonding material. If the anti-tilting member 100 is formed of a material having too high reactivity, the anti-tilting member 100 may react with the bonding material and the shape of the anti-tilting member 100 may be melted.

When the anti-tilting member 100 is deformed, a height difference may occur between the plurality of anti-tilting members 100, and thereby tilting may occur between the power element 10 and the spacer 20.

That is, the anti-tilting member 100 may be formed of a material that has a higher melting point than the bonding material and does not react with the melted bonding material.

Accordingly, when the melted bonding material is solidified, the two members bonded may be supported by the anti-tilting members 100. For example, during the process of solidifying the bonding material forming the bonding layer 70, the spacer 20 and the power element 10 may be supported by the plurality of anti-tilting members 100 interposed therebetween.

Accordingly, even when a difference in speed at which the bonding material is solidified at each portion occurs, the spacer 20 and the power element 10 may be supported by the plurality of anti-tilting members 100 interposed therebetween.

As a result, the spacer 20 and the power element 10 can be prevented from being coupled to each other in a tilted state.

The bonding layer 60 formed between the substrates 30 and 40 and the spacer 20 may also include the plurality of anti-tilting members 100 so as to suppress the occurrence of tilting. Specifically, it can be suppressed that the first substrate 30 and the second spacer 22 are coupled to each other in a tilted state. It can also be suppressed that the second substrate 40 and the first spacer 21 are coupled to each other in a tilted state.

The bonding layer 70 formed between the substrates 30 and 40 and the power element 10 may also include the plurality of anti-tilting members 100 so as to suppress the occurrence of tilting. Specifically, it can be suppressed that the first substrate 30 and the first power element 11 are coupled to each other in the tilted state. It can also be suppressed that the second substrate 40 and the second spacer 12 are coupled to each other in the tilted state.

In one implementation, the bonding layers 50, 60, and 70 may be formed of a material including copper (Cu).

In one implementation, the bonding layers 50, 60, and 70 may be formed of tin-copper alloy (Sn-Cu).

In one implementation, the anti-tilting member 100 may be formed of a nickel (Ni) material.

Since the anti-tilting members 100 are included in the bonding layer 50, 60, 70, the thickness of the bonding layer 50, 60, 70 in the up and down direction may be within a predetermined error range.

In one implementation, the thickness of the bonding layers 50, 60, 70 in the up and down direction may be formed to be within an error range of 7 µm.

In one implementation, a difference between the highest portion and the lowest portion of the bonding layer 50, 60, 70 in the up and down direction (height direction) may be 20 µm or less.

Referring to FIG. 8, a left side of the bonding layer 71 may have a first thickness H1 and a right side may have a second thickness H2.

A difference between the second thickness H2 and the first thickness H1 may be a predetermined value or less, thereby improving reliability of the power module 1.

In one implementation, the difference between the second thickness H2 and the first thickness H1 may be 7 µm or less, thereby improving the reliability of the power module 1.

Not only the bonding layer 50 formed between the spacer 20 and the power element 10 but also the other bonding layers 60 and 70 may be formed such that the error in thickness is included within the predetermined range.

In one implementation, a difference between the thickest portion and the thinnest portion of the other bonding layers 60 and 70 may be 7 µm or less.

As the tilting that may occur in the bonding layers 50, 60, and 70 is suppressed and the error in thickness is reduced, an assembly error of the entire power module 1 may be reduced.

A difference between the shortest distance between the first substrate 30 and the second substrate 40 at one end of the first substrate 30 and the shortest distance between the first substrate 30 and the second substrate 40 at another end of the first substrate 30 may be less than or equal to a predetermined value.

In one implementation, the predetermined value may be less than or equal to 20 µm.

Referring back to FIG. 3, the difference between the shortest distance D1 between the first substrate 30 and the second substrate 40 at the left end of the first substrate 30 and the shortest distance D2 between the first substrate 30 and the second substrate 40 at the right end of the first substrate 30 may be 20 µm or less.

If the difference between the shortest distance between the first substrate 30 and the second substrate 40 at the one end of the first substrate 30 and the shortest distance between the first substrate 30 and the second substrate 40 at the another end of the first substrate 30 is excessively increased, the excessive increase in thermal stress and the deterioration in heat dissipation performance may occur.

In one implementation, if the difference between the shortest distance between the first substrate 30 and the second substrate 40 at the one end of the first substrate 30 and the shortest distance between the first substrate 30 and the second substrate 40 at the another end of the first substrate 30 is 100 um or more, the problems such as the excessive increase in thermal stress and the deterioration in heat dissipation performance may occur.

In the power module 1 according to the implementation, the difference between the shortest distance D1 between the first substrate 30 and the second substrate 40 at the left end of the first substrate 30 and the shortest distance between the first substrate 30 and the second substrate 40 at the right end of the first substrate 30 is reduced to a predetermined value or less (preferably, 20 µm), the problems such as the excessive increase in thermal stress and the deterioration of the heat dissipation performance can be suppressed.

That is, it may be possible to suppress stress, which is stronger than or equal to a stress value designed to be withstood by the power element 10, from being produced on a specific portion of the power element 10 due to an increase in internal temperature of the power module.

That is, when assembling the first substrate 30 and the second substrate 40 to each other, the first substrate 30 and the second substrate 40 may form a predetermined angle that is extremely small. In one implementation, the first substrate 30 and the second substrate 40 may be coupled substantially in parallel to each other.

Accordingly, an error that may occur when assembling the first and second substrates 30 and 40 and the heat sinks (not illustrated) can be reduced. The thermal conduction performance between the first substrate 30 and/or the second substrate 40 and the heat sinks (not illustrated) can thusly be improved.

This may result in improvement of the heat dissipation performance of the power element 10.

In addition, when the first substrate 30 and the second substrate 40 are temporarily fixed to a mold, an assembly error can be reduced.

Therefore, excessive stress can be suppressed from being applied to a specific portion of the power element 10 by the mold.

### (3) Description of Arrangement of Anti-tilting member 100 according to Implementation

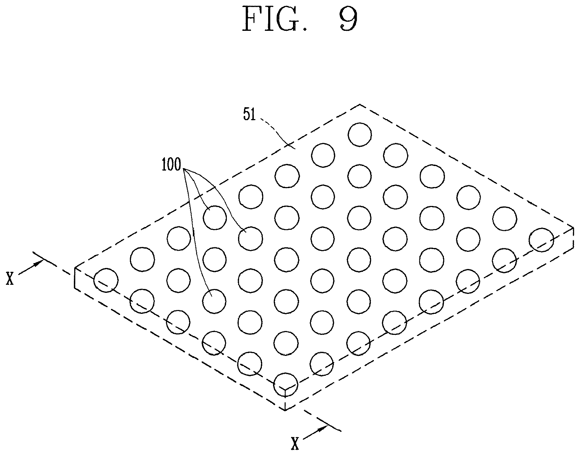

Referring to FIGS. 9 to 11, the plurality of anti-tilting members 100 may be evenly disposed in the entire first bonding layer 51.

The first bonding layer 51 may have a rectangular cross section, and some of the plurality of anti-tilting members 100 may be disposed at vertexes of the rectangle, respectively. Accordingly, when the first substrate 30 and the first power element 11 are coupled to each other, the first power element 11 may be prevented from being tilted with respect to the first substrate 30.

In one implementation not illustrated, the first bonding layer 51 may have a polygonal cross section, and some of the plurality of anti-tilting members 100 may be disposed at vertexes of the polygon, respectively.

In addition, some of the plurality of anti-tilting members 100 may be disposed on a periphery of the first bonding layer 51. Accordingly, when the first substrate 30 and the first power element 11 are coupled to each other, the first power element 11 may be prevented from being tilted with respect to the first substrate 30.

Although not illustrated, a plurality of anti-tilting members 100 included in another bonding layer 52, 61, 62, 71, 72 may also be disposed like the plurality of anti-tilting members 100 included in the first bonding layer 51.

The anti-tilting member 100 may be formed in a spherical shape.

However, the present disclosure is not limited thereto, and the ant-tilting member 100 may alternatively be formed in a polygonal column shape having a predetermined height in an up and down direction.

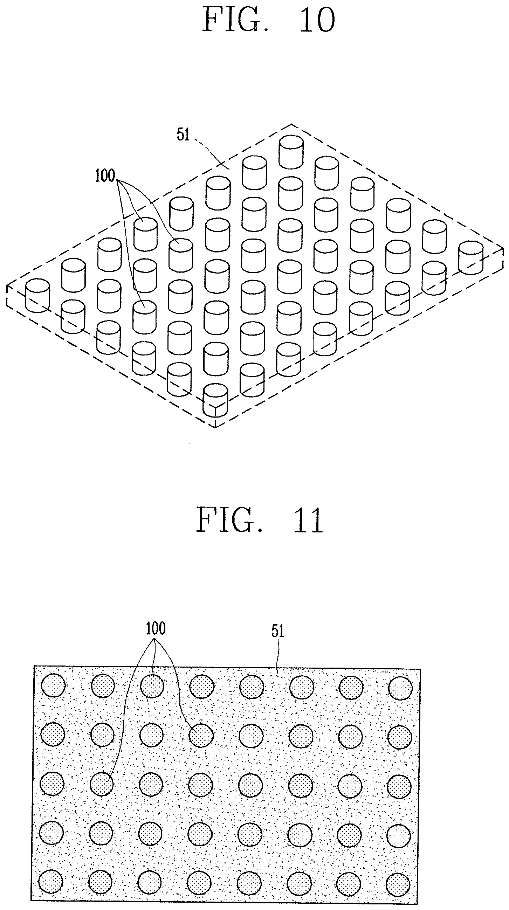

Referring to FIG. 10, the anti-tilting member 100 may be formed in a cylindrical shape.

### (4) Description of Area ratio of Bonding layer 50, 60, 70 and Anti-tilting member 100

In order to prevent an excessive reduction of bonding performance of the bonding layers 50, 60, and 70 and simultaneously to reduce an assembly error caused due to an occurrence of tilting, a mixing ratio of the bonding layer 50, 60, 70 and the plurality of anti-tilting members 100 may preferably be designed.

If the anti-tilting members 100 are excessively included in the bonding layer 50, 60, 70, the bonding performance of the bonding layer 50, 60, 70 may be reduced, which may cause reliability of the power module 1 to be lowered.

In addition, if an excessively small amount of anti-tilting members 100 is included in the bonding layer 50, 60, 70, the assembly error outside a designed assembly error range may occur.

Accordingly, the anti-tilting members 100 may preferably be included in the bonding layer 50, 60, 70 by an amount that is large enough to allow the assembly error of the power module 1 to be within the designed error range and to suppress the bonding performance of the bonding layer 50, 60, 70 from being excessively deteriorated.

Explaining the first bonding layer 51 as an example, a ratio of the anti-tilting members 100 and the bonding material may be designated as follows.

Referring to FIG. 11, on a plane passing through centers of the plurality of anti-tilting members 100, a cross-sectional area of the first bonding layer 51 may be defined as a first area A1, and the sum of cross-sectional areas of the plurality of anti-tilting members 100 may be defined as a second area A2.

In one implementation, the second area A2 may be in the range of 20% to 25% of the first area A1.

Accordingly, the bonding performance of the first bonding layer 51 may not be excessively deteriorated, and the assembly error of the power module 1 may be within the designed error range.

### 5. Description of Method for manufacturing Power module 1 according to Implementation

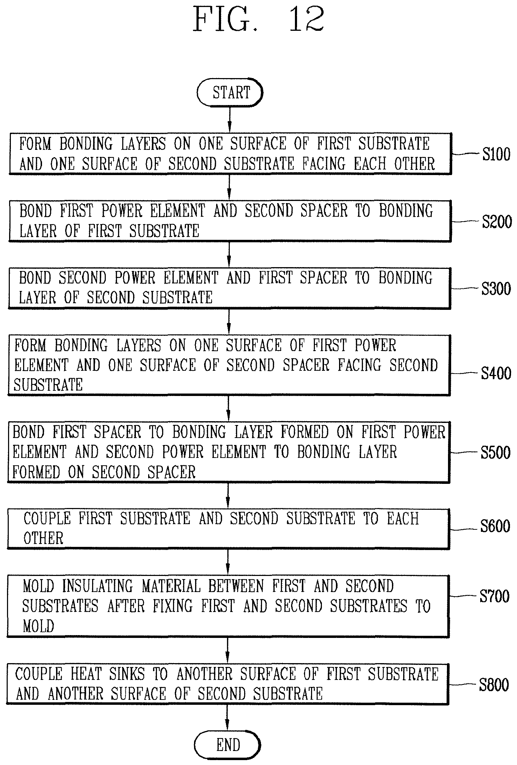

Referring to FIG. 12, a flowchart of a process of manufacturing the power module 1 according to an implementation of the present disclosure is shown.

### (1) Description of Step (S100) of forming Bonding layers 51, 52, 61, 62 on surfaces of First substrate 30 and Second substrate 40 facing each other

First, for bonding with the power element 10 and the spacer 20, a bonding material may be melted to be applied to the upper surface of the first substrate 30 and the lower surface of the second substrate 40. The bonding material may be a material having excellent thermal conductivity and electrical conductivity.

The bonding material may be soldered to positions corresponding to components to be mounted on the upper surface of the first substrate 30. In addition, the bonding material may be soldered to positions corresponding to components to be mounted on the lower surface of the second substrate 40.

As the bonding material is soldered, the first bonding layer 51 and the second bonding layer 62 may be formed on the upper surface of the first substrate 30. Also, the second bonding layer 52 and the first bonding layer 61 may be formed on the lower surface of the second substrate 40.

That is, the bonding material may be soldered to positions where the first power element 11 and the second spacer 22 are to be mounted on the first substrate 30, and positions where the second power element 12 and the first spacer 21 are to be mounted on the second substrate 40.

The melted bonding material may contain the plurality of anti-tilting members 100.

By virtue of the anti-tilting members 100, an assembly error due to tilting of the power module 1 can be reduced.

The structure, arrangement, and function of the plurality of anti-tilting members 100 and the effects obtained by the reduction of the assembly error have been described above, and thus description thereof will be omitted.

The power elements 10, diodes (not illustrated), lead frames (not illustrated), and the like may be mounted on the upper surface of the first substrate 30 and the lower surface of the second substrate 40.

The upper surface of the first substrate 30 to which the melted bonding material has been applied may face the lower surface of the second substrate 40 that is disposed to be spaced apart from the first substrate 30 by a predetermined distance.

### (2) Description of Step (S200) of bonding First power element 11 and Second spacer 22 to Bonding layers 51 and 62 of First substrate 30

The first power element 11 and the second spacer 22 may be placed on the melted and applied bonding material.

The first power element 11 may be pressed with predetermined pressure toward the upper surface of the first substrate 30. The predetermined pressure may be pressure designed for the bonding between the first power element 11 and the first substrate 30.

In the state where the first power element 11 and the first substrate 30 face each other, the melted bonding material may be solidified. Accordingly, the first power element 11 and the first substrate 30 may be bonded to each other.

During the process of solidifying the bonding material, since the first power element 11 and the first substrate 30 are supported by the plurality of anti-tilting members 100 interposed therebetween, the first power element 11 may be prevented from being mounted in a tilted state with respect to the first substrate 30.

Also, the second spacer 22 may be pressed with predetermined pressure toward the upper surface of the first substrate 30. The predetermined pressure may be pressure designed for the bonding between the second spacer 22 and the first substrate 30.

In the state where the second spacer 22 and the first substrate 30 face each other, the melted bonding material may be solidified. Accordingly, the second spacer 22 and the first substrate 30 may be bonded to each other.

During the process of solidifying the bonding material, since the second spacer 22 and the first substrate 30 are supported by the plurality of anti-tilting members 100 interposed therebetween, the second spacer 22 may be prevented from being mounted in a tilted state with respect to the first substrate 30.

In addition to the first power element 11 and the second spacer 22, the diodes (not illustrated) and the lead frames (not illustrated) may also be mounted on the upper surface of the first substrate 30 in the same manner.

The first power element 11 and the second spacer 22 mounted on the upper surface of the first substrate 30 may be electrically connected to the first substrate 30.

The first power element 11 and the second spacer 22 may be provided in plurality to be arranged according to the aforementioned arrangement structure.

### (3) Description of Step (S300) of bonding Second power element 12 and First spacer 21 to Bonding layers 52 and 61 of Second substrate 40

The second power element 12 and the first spacer 21 may be placed on the melted and applied bonding material.

The second power element 12 may be pressed with predetermined pressure toward the lower surface of the second substrate 40. The predetermined pressure may be pressure designed for the bonding between the second power element 12 and the second substrate 40.

In a state where the second power element 12 and the second substrate 40 face each other, the melted bonding material may be solidified. Accordingly, the second power element 12 and the second substrate 40 may be bonded to each other.

During the process of solidifying the bonding material, since the second power element 12 and the second substrate 40 are supported by the plurality of anti-tilting members 100 interposed therebetween, the second power element 12 may be prevented from being mounted in a tilted state with respect to the second substrate 40.

Also, the first spacer 21 may be pressed with predetermined pressure toward the lower surface of the second substrate 40. The predetermined pressure may be pressure designed for the bonding between the first spacer 21 and the second substrate 40.

In a state where the first spacer 21 and the second substrate 40 face each other, the melted bonding material may be solidified. Accordingly, the first spacer 21 and the second substrate 40 may be bonded to each other.

During the process of solidifying the bonding material, since the first spacer 21 and the second substrate 40 are supported by the plurality of anti-tilting members 100 interposed therebetween, the first spacer 21 may be prevented from being mounted in a tilted state with respect to the second substrate 40.

In addition to the second power element 12 and the first spacer 21, the diodes (not illustrated) and the lead frames (not illustrated) may also be mounted on the lower surface of the second substrate 40 in the same manner.

The second power element 12 and the first spacer 21 mounted on the upper surface of the second substrate 40 may be electrically connected to the second substrate 40.

The second power element 12 and the first spacer 21 may be provided in plurality to be arranged according to the aforementioned arrangement structure.

### (4) Description of Step (S400) of forming Bonding layers 71 and 72 on upper surfaces of First power element 11 and Second spacer 22 facing Second substrate 40

For bonding between the first substrate 30 and the second substrate 40, a bonding material may be melted to be applied to the upper surfaces of the first power element 11 and the second spacer 21. The bonding material may be a material having excellent thermal conductivity and electrical conductivity.

Accordingly, the first bonding layer 71 may be formed on the upper surface of the first power element 11 and the second bonding layer 72 may be formed on the upper surface of the second spacer 21.

The melted bonding material may contain the plurality of anti-tilting members 100.

By virtue of the anti-tilting members 100, an assembly error due to tilting of the power module 1 can be reduced.

The structure, arrangement, and function of the plurality of anti-tilting members 100 and the effects obtained by the reduction of the assembly error have been described above, and thus description thereof will be omitted.

### (5) Description of Step (S500) of bonding First spacer 21 to Bonding layer 71 formed on First power element 11, and Second power element 12 to Bonding layer 72 formed on Second spacer 22

The first spacer 21 may be disposed on the upper surface of the first bonding layer 71, and the second power element 12 may be disposed on the upper surface of the second bonding layer 72.

The first spacer 21 and the second power element 12 may be pressed with predetermined pressure toward the first substrate 30. That is, the first spacer 21 and the second power element 12 may be pressed with the predetermined pressure toward the first power element 11 and the second spacer 22, respectively.

The predetermined pressure may be pressure designed for the adhesion between the first spacer 21 and the first power element 11 and between the second spacer 22 and the second power element 12.

### (6) Description of Step (S600) of bonding First substrate 30 and Second substrate 40

As the melted bonding material is solidified, the first spacer 21 and the first power element 11 may be bonded to each other, and the second spacer 22 and the second power element 12 may be bonded to each other.

During the process of solidifying the bonding material, the plurality of anti-tilting members 100 may be interposed between the first spacer 21 and the first power element 11 and between the second spacer 22 and the second power element 12 so as to support each of them, thereby suppressing an occurrence of tilting.

### (7) Description of Step (S700) of fixing First and Second Substrates 30 and 40 to Mold and molding Insulating material between First and Second Substrates 30 and 40

After the first substrate 30, the power element 10, the spacer 20, and the second substrate 40 are assembled together, an insulating material may be molded between the first substrate 30 and the second substrate 40.

In a state where the assembled first and second substrates 30 and 40 are pressed and temporarily fixed to the mold, the insulating material may be applied between the first and second substrates 30 and 40 so as to form the insulation part 80.

As the insulation part 80 is formed, insulation internal pressure of the power element 10 may be secured. In addition, since the power element 10 is not exposed to outside, the power element 10 can be protected from the outside.

### (8) Description of Step (S800) of coupling Heat Sinks to lower surface of First substrate 30 and upper surface of Second substrate 40

Heat sinks (not illustrated) may be coupled to the lower surface of the first substrate 30 and the upper surface of the second substrate 40, respectively.

Heat generated from the power element 10 may be dissipated through the heat sinks coupled to the first and second substrates 30 and 40.

That is, heat generated from the power element 10 may be dissipated to the both upper and lower surfaces of the power element 10.

In particular, since the first power element 11 and the second power element 12 are evenly coupled to the first substrate 30 and the second substrate 40, the heat may be uniformly dissipated toward the first substrate 30 and the second substrate 40.

Accordingly, an excessive increase in internal temperature of the power module 1 due to the heat generated from the power element 10 can be suppressed.

In particular, an excessive increase in temperature of any one of the first substrate 30 and the second substrate 40 can be suppressed.

Damage to the power element 10 which is caused due to the excessive increase in the internal temperature of the power module 1 can be prevented by such double-sided heat dissipation. In particular, the damage to the power module 1 which is caused due to the excessive increase in the temperature of any of the first substrate 30 and the second substrate 40 can be suppressed.

In addition, since an assembly error that may occur in the power module 1 can be reduced by the plurality of anti-tilting members 100, the separation between the first and second substrates 30 and 40 and the heat sinks can be prevented.

Accordingly, heat transfer efficiency can be improved between the first and second substrates 30 and 40 and the heat sinks.

Therefore, the heat generated from the power element 10 can be effectively dissipated, and the damage to the power element 10 due to the excessive increase in the internal temperature of the power module 1 can be suppressed.

## Claims

1. A power module comprising:
a first substrate (30) and a second substrate (40) spaced apart from each other by a predetermined distance; and
a power element (10) and a spacer (20) disposed between the first substrate (30) and the second substrate (40),
**characterized in that**
the spacer (20) comprises:
a first spacer (21) electrically connected to one surface of the second substrate (40) facing the first substrate (30); and
a second spacer (22) electrically connected to one surface of the first substrate (30) facing the second substrate (40),
the power element (10) comprises:
a first power element (11) disposed between the first spacer (21) and the first substrate (30), and having both surfaces thereof electrically coupled to the first spacer (21) and the first substrate (30), respectively; and
a second power element (12) disposed between the second spacer (22) and the second substrate (40), and having both surfaces thereof electrically coupled to the second spacer (22) and the second substrate (40), respectively.

2. The power module of claim 1, wherein each of the first substrate (30) and the second substrate (40) comprises:
an insulating plate (31, 41); and
metal plates (32, 42) disposed on both surfaces of the insulating plate (31, 41).

3. The power module of claim 2, wherein the first substrate (30) and the second spacer (22) are coupled to one of the metal plates (32, 42) disposed on one surface of the first substrate (30) facing the second substrate (40), and
the second substrate (40) and the first spacer (22) are coupled to one of the metal plate (32, 42) disposed on one surface of the second substrate (40) facing the first substrate (30).

4. The power module of any of claims 1 to 3, wherein the first and second power elements (11, 12) are configured as insulated gate bipolar transistor, IGBT, semiconductor devices.

5. The power module of any of claims 1 to 4, wherein the first and second power elements (11, 12) are provided in plurality, and
the first power elements (11) and the second power elements (12) are provided in the same number.

6. The power module of any of claims 1 to 5, wherein the first and second power elements (11, 12) are provided in plurality,
the plurality of first power elements (11) is disposed to be spaced apart from each other by a predetermined distance along a first row, and
the plurality of second power elements (12) is disposed to be spaced apart from each other by a predetermined distance along a second row spaced apart from the first row.

7. The power module of any of claims 1 to 6, wherein the first and second power elements (11, 12) are provided in plurality,
at least one of the plurality of second power elements (12) is disposed between the plurality of first power elements (11), and
at least one of the plurality of first power elements (11) is disposed between the plurality of second power elements (12).

8. The power module of claim 6 or 7, wherein the first and second power elements (11, 12) are provided in plurality,
the plurality of first and second power elements (11, 12) is disposed to be spaced apart from each other by a predetermined distance along the first row and the second row spaced apart from the first row,
at least one of the plurality of second power elements (11, 12) is disposed between the plurality of first power elements (11) disposed in the first row, and
at least one of the plurality of first power elements (11) is disposed between the plurality of second power elements (12) disposed in the second row.

9. The power module of any of claims 1 to 8, further comprising a plurality of bonding layers (50, 60, 70) formed between the power element (10) and the spacer (20), between the power element (10) and the first substrate (30), and between the spacer (20) and the second substrate (40), respectively,
wherein at least one of the plurality of bonding layers (50, 60, 70) includes a plurality of anti-tilting members (100),
the plurality of anti-tilting members (100) each has a predetermined height in a direction that the first and second substrates (30, 40) face each other, and
the anti-tilting members (100) are melted at a higher temperature than the plurality of bonding layers (50, 60, 70).

10. The power module of claim 9, wherein the bonding layers (50, 60, 70) each has a predetermined thickness in the direction that the first substrate (30) and the second substrate (40) face each other, and
the predetermined height of the anti-tilting member (100) and the predetermined thickness of the bonding layer (50, 60, 70) are equal to each other.

11. The power module of any one of claims 1 to 9, wherein a difference between a shortest distance between the first substrate (30) and the second substrate (40) at one end of the first substrate (30) and a shortest distance between the first substrate (30) and the second substrate (40) at another end of the first substrate (30) opposite to the one end is 200 um or less.

12. A method for manufacturing a power module, the method **characterized by** comprising:
(a) forming bonding layers (50, 60, 70) respectively on one surface of a first substrate (30) and one surface of a second substrate (40) facing each other;
(b) bonding a first power element (11) and a second spacer (22) to the bonding layer (50, 60, 70) of the first substrate (30);
(c) bonding a second power element (12) and a first spacer (21) to the bonding layer (50, 60, 70) of the second substrate (40);
(d) forming bonding layers (50, 60, 70) respectively on one surface of the first power element (11) and one surface of the second spacer (22) facing the second substrate (40);
(e) bonding the first spacer (21) to the bonding layer (50, 60, 70) formed on the first power element (11) and the second power element (12) to the bonding layer (50, 60, 70) formed on the second spacer (22); and
(f) coupling the first substrate (30) and the second substrate (40) to each other.

13. The method of claim 12, wherein the bonding layers (50, 60, 70) each includes a plurality of anti-tilting members (100),
the plurality of anti-tilting members (100) each has a predetermined height in a direction that the first and second substrates (30, 40) face each other, and
the anti-tilting members (100) are melted at a higher temperature than the plurality of bonding layers (50, 60, 70).

14. The method of claim 12 or 13, wherein the first and second power elements (11, 12) are provided in plurality,
the first power elements (11) and the second power elements (12) are provided in the same number.

15. The method of any of claims 12 to 14, wherein the first and second power elements (11, 12) are provided in plurality,
the plurality of first and second power elements (11, 12) is disposed to be spaced apart from each other by a predetermined distance along a first row and a second row spaced apart from the first row,
at least one of the plurality of second power elements (12) is disposed between the plurality of first power elements (11) disposed in the first row, and
at least one of the plurality of first power elements (11) is disposed between the plurality of second power elements (12) disposed in the second row.
